# EUROPÄISCHE PATENTSCHRIFT

(11) **EP 1 256 172 B1**
(45) Veröffentlichungstag und Bekanntmachung des Hinweises auf die Patenterteilung: **24.06.2009**
(21) Anmeldenummer: 01919126.1
(22) Anmeldetag: 02.02.2001
(51) Int. Cl.: H03M 1/00

(54) **OBERFLÄCHENWELLENFILTER MIT REAKTANZELEMENTEN**
SURFACE WAVE FILTER COMPRISING REACTANCE ELEMENTS
FILTRE A ONDES ACOUSTIQUES DE SURFACE DOTE D'ELEMENTS DE REACTANCE

(30) Priorität: 17.02.2000 DE 10007178
(43) Veröffentlichungstag der Anmeldung: 13.11.2002
(73) Patentinhaber: EPCOS AG, 81669 München (DE)
(72) Erfinder: BAIER, Thomas, D-81827 München (DE); UNTERBERGER, Michael, 82008 Unterhaching (DE)
(74) Vertreter: Epping - Hermann - Fischer
(86) Internationale Anmeldenummer: PCT/DE2001/000406
(87) Internationale Veröffentlichungsnummer: WO 2001/061859

(56) Entgegenhaltungen:
- EP-A- 0 772 293
- EP-A- 0 940 915
- WO-A-97/45955
- DE-A- 19 638 370
- DE-A- 19 818 038
- US-A- 4 906 885
- US-A- 5 363 073
- US-A- 5 499 003
- US-A- 5 790 000

## Beschreibung

In GSM-Mobiltelefonen werden heute zum großen Teil Oberflächenwellenfilter oder kurz OFW-Filter eingesetzt, die eingangsseitig single ended und ausgangsseitig balanced betrieben werden. Single ended bedeutet dabei, dass nur einer der beiden Anschlüsse mit dem Signal belegt wird, während der andere auf Masse liegt. Diese Anschlussweise wird auch als unsymmetrisch bezeichnet. Ein balanced betriebener Ein- oder Ausgang eines OFW-Filters weist dagegen zwei Anschlüsse auf, deren Signale idealerweise gegeneinander um 180° phasenverschoben sind. Das heißt, an beiden Anschlüssen kann ein betragsmäßig gleiches Signal erhalten werden, das sich lediglich im Vorzeichen unterscheidet. Ein solcher symmetrischer/unsymmetrischer Betrieb wird auch als BALUN Funktion bezeichnet.

Für neuere Mobilfunksysteme wie EDGE, UMTS und CDMA verlangt der Markt zunehmend nach OFW HF-Filtern, die beidseitig im Balanced Mode betrieben werden können. Teilweise werden solche Filter auch schon in etablierten Mobilfunksystemen unter AMPS, PCS und PDC 1.5 eingebaut.

Ein weiterer, für die Betriebsweise eines OFW-Filters wichtiger Faktor ist die Filterimpedanz. Wurden bislang zumeist ein- und ausgangsseitig einheitlich 50 Ohm Filterimpedanz verlangt und angeboten, werden nun zunehmend für Balanced-Balanced Filter auch höhere Impedanzen im Bereich von 100 bis 400 Ohm benötigt.

Insbesondere bei der Verwendung im Mobilfunk muss ein OFW HF-Filter auch bezüglich Selektion und Einfügedämpfung höchsten Anforderungen genügen. Diese lassen sich nur mit speziellen neuartigen Filterstrukturen verwirklichen.

Aus der DE 198 18 038 A ist ein HF-Filter bekannt, bei dem in einer In-line Anordnung drei voneinander mittels Reflektoren getrennte parallel geschaltete DMS-Filter angeordnet sind.

Aus der EP-A-0 940 915 ist eine Filteranordnung bekannt, bei der ein DMS-Filter ein- und ausgangsseitig mit je einem Eintorresonator in Serie geschaltet ist.

Aus der US-A-5 499 003 ist eine Reaktanzfilteranordnung bekannt, die aus einer Verschaltung serieller und paralleler Eintorresonatoren bekannt, die in zwei seriellen Zweigen und diese überbrückenden Querzweigen angeordnet sind.

Aus der DE 196 38 370 A ist eine Reaktanzfilteranordnung bekannt, die zwei zwischen Ein- und Ausgang verschaltete serielle Zweige mit darin angeordneten Serienresonatoren aufweist, wobei die beiden seriellen Zweige mit einem Querzweig verbunden sind, in dem zwei Parallelresonatoren angeordnet sind.

Bekannte Filter, die beidseitig im Balanced Mode betrieben werden können, sind beispielsweise aus der EP-A 0 605 884 bekannt. Diese sind auf der Basis von Longitudinalmodenresonatorfiltern (= Dualmode-OFW = DMS-Filter) auf Lithiumniobat oder Lithiumtantalat realisiert. Diese Filter weisen je Spur eine ungerade Anzahl von zwischen zwei Reflektoren angeordneten Interdigitalwandlern auf. Ein Balanced-Balanced Filter ist beispielsweise als Zweispurfilter ausgebildet, bei dem zwei Spuren mit je drei Wandlern jeweils über den mittlern Wandler in Kaskade geschaltet sind. Jeweils die beiden äußeren Wandler einer Spur sind mit dem Ein- oder Ausgang verbunden und weisen eine Phaseninversion auf, so daß ein symmetrischer Betrieb am jeweiligen Ein- oder Ausgang möglich ist. Ein solches Filter besitzt ein- und ausgangsseitig die gleiche Impedanz.

Aufgabe der vorliegenden Erfindung ist es, beidseitig im Balanced Mode betreibbare Filter zur Verfügung zu stellen, die eine hohe Selektion und eine niedrige Einfügedampfung aufweisen.

Diese Aufgabe wird erfindungsgemäß durch ein Oberflächenwellen-Filter nach Anspruch 1 gelöst. Vorteilhafte Ausgestaltungen der Erfindung gehen aus den Unteransprüchen hervor.

Die Erfindung schlägt erstmals vor, ein beidseitig im Balanced Mode betreibbares HF-Filter mit Reaktanzelementen auf OFW-Basis aufzubauen. Ein Reaktanzelement auf OFW-Basis kann dabei als OFW-Resonator ausgebildet sein. Das erfindungsgemäße Filter ist elektrisch vollkommen symmetrisch aufgebaut. Es weist zumindest ein vierpoliges Reaktanzserienelement auf, wobei je zwei Pole (=Anschlüsse) den symmetrischen Ein- bzw. Ausgang bilden. Ein vierpoliges Reaktanzserienelement wird dabei durch ein einziges (vierpoliges) Reaktanzelement mit vier Anschlüssen (Polen) gebildet. Unter Reaktanzserienelement wird im Sinn der Erfindung ein OFW-Reaktanzelement verstanden, welches zwei Interdigitalwandler aufweist, die zwischen zwei Reflektoren angeordnet sind, von denen jeweils eine Stromschiene mit der Eingangsseite, die andere Stromschiene mit der Ausgangsseite verbunden ist, so daß eine serielle Verbindung (Pfad) zwischen Ein- und Ausgangsseite hergestellt ist, in die das Reaktanzserienelement eingebettet ist.

Ein vierpoliges Reaktanzserienelement stellt eine Basisstruktur für ein rudimentäres OFW-HF-Filter dar, das die genannte Aufgabe in einfacher Weise löst. Bisherige Reaktanzfilter weisen eine unsymmetrische Struktur auf und besitzen beidseitig jeweils nur einen signalführenden Anschluss, also einen single ended Anschluss, während der andere Anschluss mit Masse verbunden ist. Ein solches bekanntes Reaktanzfilter besitzt daher nur einen seriellen Pfad, der die beiden signalführenden Anschlüsse an Ein- und Ausgangsseite miteinander verbindet. Der Anschluß zur Masse wird über parallel dazu geschaltete Resonatoren bzw. Reaktanzelemente vorgenommen. Die gesamte Anordnung bekannter Reaktanzfilter ist daher sowohl elektrisch als auch geometrisch unsymmetrisch.

Es können die beiden jeweils ein Reaktanzelement bzw. einen Resonator aufweisenden seriellen Pfade über zumindest einen parallelen Ast symmetrisch miteinander verbunden werden, wobei ein vollwertiges HF Filter erhalten wird. Im einfachsten Fall kann dies ein parallel dazu geschalteter OFW-Resonator sein.

Erfindungsgemäß sind die Ein- oder Ausgänge des vierpoligen Reaktanzserienelements mit dem symmetrischen Eingang eines beidseitig symmetrischen DMS-Filters verbunden. Die Ausgänge des DMS-Filters stellen dann den Aus- bzw. Eingang eines vollwertigen erfindungsgemäßen Filters dar.

In einer weiteren Ausgestaltung ist ebenfalls ein paralleler Ast zwischen den beiden seriellen Pfaden vorgesehen, in dem zwei in Serie geschaltete Reaktanzelemente bzw. Resonatoren angeordnet sind, die akustisch nicht gekoppelt sind. Als paralleles Reaktanzelement kann auch ein Resonator eingesetzt werden, dessen eine Stromschiene achsensymmetrisch in zwei Teile aufgeteilt ist, die jeweils mit den beiden Anschlüssen des Interdigitalwandlers verbunden sind. Die gegenüberliegende Stromschiene des so geteilten Interdigitalwandlers stellt einen virtuellen Massepunkt dar, der ggf. auch mit einem Masseanschluß verbunden werden kann.

Ein vierpoliges einzelnes Reaktanzserienelement wird auch erhalten, wenn der Interdigitalwandler eines Oberflächenwellenresonators symmetrisch in zwei Teilwandler zerlegt wird, die jeweils zwei Anschlüsse aufweisen. Beiderseits der akustischen Spur des Resonators sind dann symmetrische Ein- und Ausgänge ausgebildet, die die Ein- und Ausgänge einer Basisstruktur eines mit weiteren symmetrischen OFW-Komponenten voll funktionsfähigen hochsymmetrischen HF-Filters darstellen.

In einer weiteren Ausgestaltung der Erfindung kann das vierpolige Reaktanzserienelement symmetrisch mit weiteren Reaktanzelementen oder auch DMS-Filtern in Kaskade geschaltet werden. So kann ein in Kaskade mit dem Reaktanzserienelement geschaltetes DMS-Filter in Kaskade mit einem weiteren symmetrischen DMS-Filter stehen. Möglich ist es auch, zwei symmetrische DMS-Filter über das dazwischen geschaltete vierpolige Reaktanzserienelement miteinander zu verbinden. Jedes der DMS-Filter kann dabei wiederum kaskadiert sein, also mehrere in Kaskade geschaltete akustische Spuren aufweisen.

In einer weiteren Ausgestaltung der Erfindung sind in elektrisch symmetrischer Verschaltung zwei vierpolige Reaktanzelemente über Kreuz in Form einer Brückenschaltung miteinander verbunden. Dabei werden die beiden Anschlüsse des symmetrischen Eingangs des ersten vierpoligen Reaktanzelements mit jeweils einem Anschluß von Ein- und Ausgang des zweiten vierpoligen Reaktanzelements verbunden. Die beiden Anschlüsse des Ausgangs des ersten Reaktanzelements werden mit dem jeweils anderen Anschluss von Ein- und Ausgang des zweiten Reaktanzelements verbunden. Dies ist die einzige Ausführung der Erfindung, die keine geometrisch symmetrische Anordnung darstellt, sondern nur eine elektrisch symmetrische.

Ein erfindungsgemäßes Reaktanzfilter kann auch eine DMS Spur oder einen Resonator enthalten, bei dem zwei nebeneinander liegende Oberflächenwellenstrukturen, unabhängig voneinander ausgewählt aus Interdigitalwandler und Reflektor gegeneinander phasenverschoben sind. Der Übergang zwischen den beiden phasenverschobenen Oberflächenwellenstrukturen wird dabei durch eine kontinuierlich variierte Fingerperiode und durch kontinuierlich variierte Fingerabstände, oder nur durch eine kontinuierlich variierte Fingerperiode gestaltet, wobei die Fingerperiode im Bereich des Übergangs ein Minimum aufweist und von beiden Seiten her kontinuierlich abnimmt. Damit werden Streuverluste im HF Filter vermieden.

In einer weiteren Ausgestaltung der Erfindung können einzelne oder mehrere Interdigitalwandler von Reaktanzelementen oder mit diesen verschalteten DMS-Filtern bzw. DMS-Spuren gewichtet sein, um verschiedene Parameter des gesamten Filters anzupassen. Beispielsweise kann damit die Bandbreite des Filters variiert, die Impedanz des Filters verändert oder die Selektion erhöht werden. Eine solche Wichtung kann als Weglasswichtung oder Überlappwichtung ausgeführt sein. Weitere Beispiele für gewichtete Interdigitalwandler, die alle in erfindungsgemäßen Filtern eingesetzt werden können, sind z.B. der DE-A-19724259 (= 97P1705) zu entnehmen, auf die hiermit vollinhaltlich Bezug genommen wird.

Möglich ist es jedoch auch, bei einem Interdigitalwandler eine Kaskaden-Wichtung durchzuführen. Dazu wird ein Teil des Interdigitalwandlers durch zwei oder mehrere in Serie verschaltete Teilwandler mit jeweils reduzierter Spurbreite ersetzt. Die serielle Verschaltung der Teilwandler kann dabei durch eine in einen herkömmlichen Interdigitalwandler eingezogene zusätzliche Stromschiene mit entsprechend veränderter Fingeranschlussfolge erreicht werden. Dabei ist es auch möglich, daß eine innere Stromschiene nicht über die gesamte Länge des Interdigitalwandlers reicht. Im Ergebnis wird dann ein Interdigitalwandler erhalten, der in mehrere parallel geschaltete Teilwandler aufgeteilt ist, wobei einer dieser Teilwandler nochmals in zwei oder mehr seriell verschaltete Teilwandler aufgeteilt ist. So läßt sich in einfacher Weise die Impedanz des Interdigitalwandlers und damit auch diejenige des Ein- oder Ausgangs oder des Reaktanzelementes oder des Filters erhöhen.

Vorzugsweise ist ein erfindungsgemäßes Filter auf einem einzigen Substrat aufgebaut, wobei Lithiumtantalat und Lithiumniobat bevorzugt sind.

Für die Metallisierung auf diesen Substratmaterialien sind Elektrodenstrukturen aus Aluminium, aus Aluminium/Kupferlegierung, aus Aluminium- und Kupferschichten, aus Aluminium/Magnesiumlegierung oder aus Aluminium- und Magnesiumschichten geeignet. Diese zeichnen sich z.B. durch eine gute Haftung auf dem Substratmaterial aus.

Ein erfindungsgemäßes OFW-HF-Filter ist auch in der Verwirklichung auf dem piezoelektrischen Substrat geometrisch hochsymmetrisch - mit Ausnahme der Brückenschaltung. Dies hat zur Folge, daß auch die elektrischen Anschlüsse (Pole) symmetrisch auf dem Substrat angeordnet sind. Wenn das erfindungsgemäße Filter in Flipchiptechnik auf einer Basisplatte montiert wird, bei der das Substrat mit zu der Basisplatte weisenden Metallisierungen über Lotkugeln oder Bumps mit der genannten Basisplatte verbunden wird, werden in ihren äußeren Ausmaßen besonders kompakte Filter erhalten.

Im folgenden wird die Erfindung anhand von Ausführungsbeispielen und der dazu gehörigen 14 Figuren näher erläutert.
- Figur 1: zeigt ein aus zwei Reaktanzelementen bestehendes vierpoliges Reaktanzserienelement,
- Figur 2: zeigt ein als vierpoliges Reaktanzelement ausgebildetes Reaktanzserienelement,
- Figur 3: zeigt zwei symmetrisch seriell verschaltete Resonatoren im parallelen Ast,
- Figur 4: zeigt einen symmetrischen parallelen Ast mit einem Reaktanzelement,
- Figur 5: zeigt eine symmetrische DMS-Filterstruktur,
- Figur 6: zeigt ein Reaktanzelement im symmetrischen parallelen Ast,
- Figur 7: zeigt ein symmetrisches Reaktanzserienelement in Kaskade mit einem symmetrischen DMS-Filter,
- Figur 8: zeigt ein symmetrisches DMS-Filter in Kaskade mit einem symmetrischen Reaktanzserienelement,
- Figur 9: zeigt ein zwischen zwei symmetrische DMS-Filter geschaltetes symmetrisches Reaktanzserienelement,
- Figur 10: zeigt zwei serielle Reaktanzelemente mit einem parallel dazu geschalteten Reaktanzelement, so dass diese ein symmetrisches Reaktanzfilter bilden,
- Figur 11: zeigt ein vierpoliges symmetrisches Reaktanzserienelement, zu dem ein zweipoliges Reaktanzelement parallel geschaltet ist, so dass symmetrisches Reaktanzfilter gebildet wird,
- Figur 12: zeigt eine Brückenschaltung aus zwei vierpoligen Reaktanzserienelementen,
- Figur 13: zeigt eine Durchlaßkurve eines erfindungsgemäßen Filters und
- Figur 14: zeigt einen teilweise in Halbspuren geteilten Interdigitalwandler für ein Reaktanzelement mit erhöhter Impedanz.

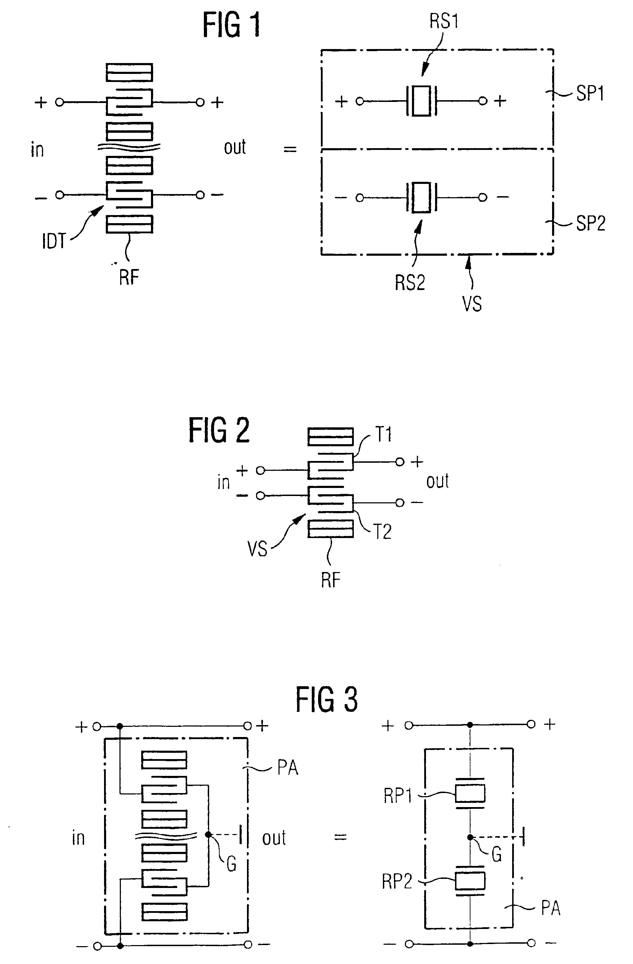

Figur 1 zeigt ein vierpoliges Reaktanzserienelement, welches als solches keine Ausführungsform der Erfindung ist, das durch zwei als Resonatoren ausgebildete geometrisch gleiche Reaktanzelemente RS ausgebildet ist. Je ein Anschluss (Pol) der beiden zweipoligen Reaktanzelemente RS1, RS2 bilden zusammen den Eingang IN, während die beiden anderen Anschlüsse den Ausgang OUT bilden. Jedes Reaktanzelement RS besteht dabei aus einem Interdigitalwandler IDT, der zwischen zwei Reflektoren RF angeordnet ist. Das erste Reaktanzelement RS1 bildet den ersten seriellen Pfad SP1, das zweite Reaktanzelement RS2 den zweiten seriellen Pfad SP2, was durch eine symbolische Schreibweise im rechten Teil der Figur 1 vereinfacht dargestellt ist. Die beiden Reaktanzelemente RS sind akustisch nicht miteinander gekoppelt, was im linken Teil der Zeichnung durch die doppelte Wellenlinie verdeutlicht ist.

Figur 2 zeigt ein vierpoliges Reaktanzserienelement, welches als solches keine Ausführungsform der Erfindung ist, das als Reaktanzelement (Resonator) mit vier Anschlüssen ausgebildet ist. Bei diesem Resonator ist der zentrale Interdigitalwandler symmetrisch in der Mitte in einen ersten Teilwandler T1 und einen zweiten Teilwandler T2 geteilt, die jeweils zwei Anschlüsse aufweisen. Jeweils zwei auf einer Seite liegende Anschlüsse werden dabei zu Eingang IN oder Ausgang OUT zusammengefasst. Ein solches vierpoliges Reaktanzelement stellt ein rudimentäres OFW-Filter dar. Aufgrund der Reziprozität von OFW-Bauelementen ist für dieses und alle weiteren erfindungsgemäßen Filter klar, dass sie auch in umgekehrter Richtung betrieben können, also in einer Betriebsweise, bei der Ein- und Ausgänge IN, OUT vertauscht sind. Dies gilt auch für die Anordnung der im folgenden beschriebenen Teilstrukturen, die mit einem solchen Reaktanzserienelement in Kaskade verschaltet werden können.

Figur 3 zeigt einen parallelen Ast PA welches als solches keine Ausführungsform der Erfindung ist, der zwischen die beiden Anschlüsse IN, OUT auf Ein- oder Ausgangsseite des Reaktanzserienelements geschaltet werden kann. Im parallelen Ast sind zwei Reaktanzelemente RP in Serie geschaltet. Zwischen den beiden Reaktanzelementen RP befindet sich ein virtueller Massepunkt G, welcher aufgrund seiner symmetrisch zentralen Lage zwischen den seriellen Pfaden ein konstantes elektrisches Potential aufweist und wahlweise auch mit Masse verbunden werden kann.

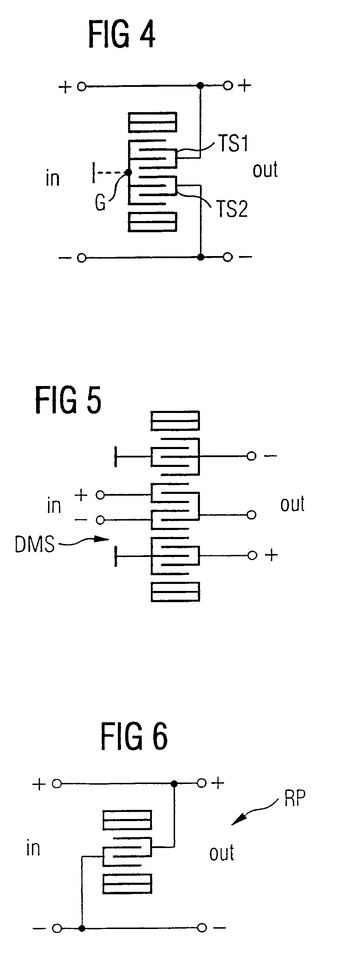

Figur 4 zeigt ein anders aufgebautes Reaktanzelement welches als solches keine Ausführungsform der Erfindung ist, das ebenfalls in einem parallelen Ast angeordnet ist, welche zwischen die beiden Anschlüsse des Ein- oder Ausgangs eins Reaktanzserienelements geschaltet werden kann. Dieses Reaktanzelement weist einen zwischen zwei Reflektoren angeordneten Interdigitalwandler auf, bei dem eine Stromschiene (in der Figur rechts dargestellt) symmetrisch in zwei Teilschienen TS1, TS2 aufgeteilt ist. Im Ergebnis ist der Interdigitalwandler in zwei in Serie verschaltete Teilwandler aufgeteilt, die zusammen ein Reaktanzelement für den parallelen Ast darstellen, die mit einem der in Figur 1 oder 2 dargestellten Reaktanzserienelemente verbunden werden können.

Figur 5 zeigt ein bekanntes für sich funktionsfähiges DMS-Filter welches als solche(s) keine Ausführungsform der Erfindung ist, welches ein- und ausgangsseitig symmetrische Anschlüsse aufweist. Dazu ist der mittlere der insgesamt drei Interdigitalwandler durch symmetrische Aufteilung einer Stromschiene mit zwei auf einer Seite der akustischen Spur liegenden Anschlüssen IN versehen. Diese bilden den symmetrischen Eingang IN. Die beiden äußeren Interdigitalwandler sind mit dem Ausgang OUT verbunden. Ein solches symmetrisches DMS-Filter kann nun - ähnlich wie ein Reaktanzelement im parallelen Ast - als zusätzliche Teilstruktur mit dem Ein- oder Ausgang eines Reaktanzserienelementes (siehe Figur 1 oder 2) verbunden werden, oder anders ausgedrückt mit diesem in Kaskade verschalten werden. Möglich ist es auch, ein DMS Filter mit einem Reaktanzserienelement, das ein Reaktanzelement im seriellen Ast aufweist, in Kaskade zu schalten.

Figur 6 zeigt eine weitere mögliche Teilstruktur welche als solche(s) keine Ausführungsform der Erfindung ist, die mit einem erfindungsgemäßen Reaktanzserienelement verbunden werden kann. In einem parallelen Ast ist hier ein einfacher OFW Resonator als paralleles Reaktanzelement RP angeordnet.

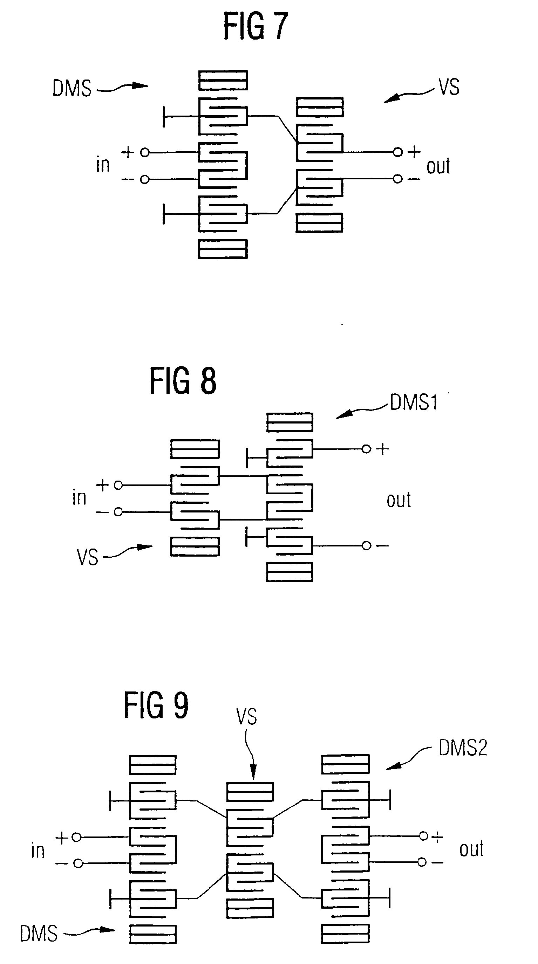

Figur 7 zeigt eine Ausführung der Erfindung, bei der ein vierpoliges Reaktanzserienelement VS in Kaskade mit einem symmetrischen DMS-Filter DMS (siehe z.B. Figur 5) verschaltet ist. Der über die äußeren Interdigitalwandler des DMS-Filters DMS gebildete Ausgang ist mit den beiden Anschlüssen des Eingangs des Reaktanzserienelements verbunden.

Figur 8 zeigt eine ähnliche Verschaltung wie Figur 7, doch ist dabei das symmetrische DMS-Filter DMS über die beiden Anschlüsse des mittleren Interdigitalwandlers mit dem Reaktanzserienelement VS verbunden.

Figur 9 zeigt ein Reaktanzserienelement VS, welches beidseitig in Kaskade mit je einem symmetrischen DMS-Filter DMS1, DMS2 verschaltet ist. In der dargestellten Ausführung sind die DMS-Filter jeweils über die äußeren Interdigitalwandler mit dem Reaktanzserienelement verbunden. Möglich ist es jedoch auch, die Verbindung des DMS-Filters zum Reaktanzserienelement über die beiden Anschlüsse des mittleren Interdigitalwandler der DMS-Filter vorzunehmen.

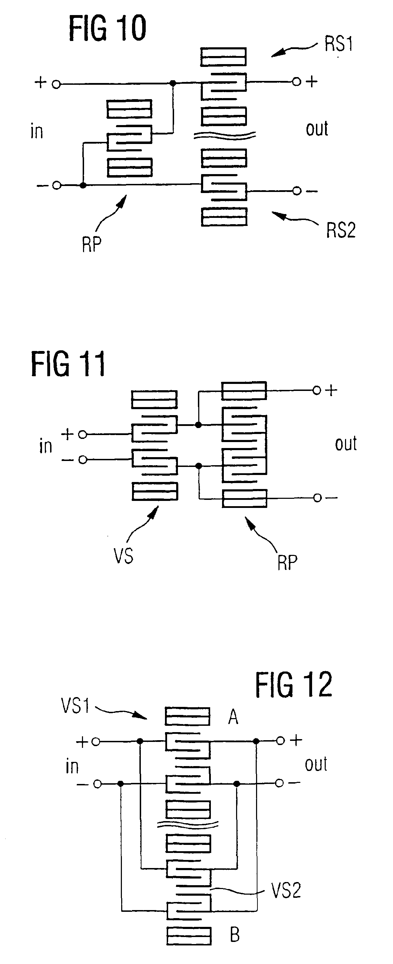

Figur 10 zeigt ein Filter welches als solches keine Ausführungsform der Erfindung ist, bei dem zwei serielle Pfade vorgesehen sind, in denen jeweils ein zweipoliges Reaktanzelement RS1, RS2 (Resonator) angeordnet ist. Die beiden seriellen Pfade sind mit einem weiteren zweipoligen Reaktanzelement bzw. mit einem zweipoligen Resonator überbrückt, der im parallelen Ast angeordnet ist. Dabei wird der Resonator (RP) im parallelen Ast in der Frequenz so gegen die Resonatoren (RS1,RS2) in den seriellen Pfaden verstimmt, dass die Resonanzfrequenzen der Resonatoren (RS1,RS2) in den seriellen Pfaden größer oder gleich der Antiresonanzfrequenz des Resonators (RP) im parallelen Ast (PA) sind.

Figur 11 zeigt ein Reaktanzserienelement VS, welches als solches keine Ausführungsform der Erfindung ist, bei dem die beiden Anschlüsse des Ausgangs OUT mit einem zweipoligen Reaktanzelement RP parallel verschaltet sind. Dieses Reaktanzelement des parallelen Asts entspricht dem in Figur 4 dargestellten Reaktanzelement mit einer aufgeteilten Stromschiene am Interdigitalwandler. In Ausgestaltung sind bei diesem Filter die elektrischen Anschlüsse für den Ausgang OUT mit den Reflektoren des Reaktanzelements im parallelen Ast verbunden, und diese mit den Ausgängen des Reaktanzserienelements VS. Auf dieser Weise können die elektrisch inaktiven Reflektoren, die ebenfalls aus metallischen Strukturen bestehen als Leiterbahnen genutzt werden. Dies erspart zusätzliche Leiterbahnen auf der Oberfläche des Chips, auf dem das Filter realisiert ist.

Figur 12 zeigt ein weiteres Filter welches als solches keine Ausführungsform der Erfindung ist, bei dem zwei vierpolige Reaktanzserienelemente VS1, VS2 über Kreuz zu einer Brücke verschaltete sind. Die Resonatoren A und B der beiden Reaktanzserienelemente sind dabei frequenzmäßig gegeneinander verstimmt, was beispielsweise durch eine unterschiedliche Fingerperiode oder einen unterschiedlichen Abstand zwischen Interdigitalwandler und Reflektoren der Resonatoren eingestellt werden kann.

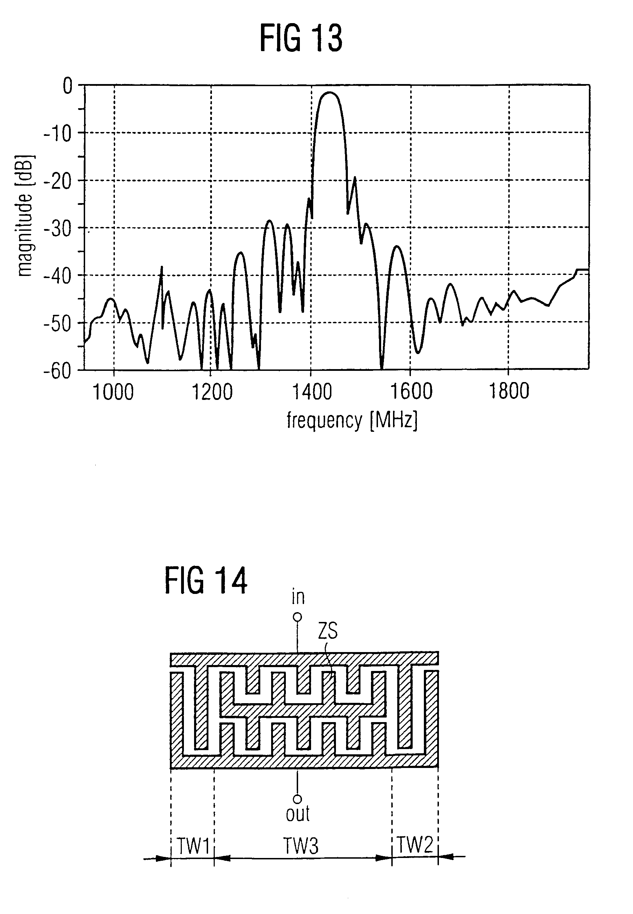

Figur 13 zeigt eine Durchlasskurve eines erfindungsgemäßen Filters, die an einem z.B. gemäß Figur 7 ausgebildeten Filter bestimmt wurde. Das Filter zeigt eine hohe Selektion von mehr als 20 dB und eine niedrige Einfügedampfung von maximal 3 dB über den gesamten Durchlaßbereich. Dieses Filter ist daher besonders gut zur Verwendung in Mobilfunksystemen einsetzbar, da es die dafür verlangten strengen Spezifikationen erfüllt. Dies gilt auch für alle übrigen in den Ausführungsbeispielen beschriebenen erfindungsgemäßen Filter.

Figur 14 zeigt einen an sich bekannten kaskadengewichteten Interdigitalwandler, der in Reaktanzelementen erfindungsgemäßer Filter oder in Kaskade zu Reaktanzserienelementen geschalteten DMS Filtern verwendet werden kann und der die Impedanz des entsprechenden Filters oder Reaktanzelements erhöht. Er weist zumindest teilweise eine zusätzliche mittlere Stromschiene ZS auf, die den Wandler in zwei seriell verschaltete Teilwandler aufteilt. In der Figur ist ein solcher Interdigitalwandler dargestellt, der sich in drei zueinander parallel geschaltete Teilwandler TW1, TW2 und TW3 aufteilen lässt, wobei der mittlere Teilwandler TW3 wiederum zwei über die zusätzliche Stromschiene ZS seriell verschaltete Teilwandler umfasst. Dieser Interdigitalwandler weist gegenüber einem normalen Interdigitalwandler eine erhöhte Impedanz auf.

Die in den Ausführungsbeispielen beschriebenen Ausgestaltungen der Erfindung stellen nur ein Teil der Lösungen dar, die durch Kombination der eben beschriebenen einzelnen Elemente möglich und darstellbar sind. Die Erfindung ist daher nicht auf die dargestellten Strukturen beschränkt und geht in ihrer allgemeinsten Form aus Anspruch 1 hervor.

## Patentansprüche

1. HF-Filter mit Reaktanzelementen auf OFW-Basis
- das auf einem piezoelektrischen Substrat aufgebaut ist
- das balanced/balanced konfiguriert ist und daher einen symmetrischen Eingang (IN) und einen symmetrischen Ausgang (OUT) mit jeweils zwei Anschlüssen aufweist
- das elektrisch symmetrisch aufgebaut ist
- mit einem vierpoligen Reaktanzserienelement (VS) mit zwei eingangsseitigen und zwei ausgangsseitigen Anschlüssen,
- wobei beide ein- oder ausgangsseitigen Anschlüsse (IN;OUT) des Reaktanzserienelements (RS) in Kaskade mit einem symmetrischen Eingang oder Ausgang eines symmetrischen DMS Filters (DMS) verbunden sind
- wobei das Reaktanzserienelement (RS) ein einzelnes symmetrisches Reaktanzelement (VS) auf OFW Basis ist, das zwei Interdigitalwandler (IDT) aufweist, die zwischen zwei Reflektoren angeordnet sind.

2. HF-Filter nach Anspruch 1,
bei dem das DMS Filter drei Interdigitalwandler aufweist, wobei der mittlere der drei Interdigitalwandler durch symmetrische Aufteilung einer Stromschiene mit zwei auf einer Seite der akustischen Spur liegenden Anschlüssen (IN) versehen ist, während die beiden äußeren Interdigitalwandler sind mit dem Ausgang (OUT) verbunden sind.

3. Filter nach Anspruch 1 oder 2,
bei dem zumindest ein paralleler Ast (PA) vorgesehen ist, in dem ein Resonator (RP) angeordnet ist, der zwischen einem erstem und einem zweitem seriellen Pfad (SP1SP2) geschaltet ist
wobei je ein Pol von erstem und zweitem seriellen Pfad den symmetrischen Eingang (IN) und die jeweils anderen Pole von erstem und zweitem seriellen Pfad den symmetrischen Ausgang (OUT) des Filters bilden.

4. Filter n nach einem der Ansprüche 1-3,
welches mit zumindest einem weiteren DMS Filter (DMS2) in Kaskade verschaltet ist.

5. Filter nach einem der Ansprüche 1-4,
bei dem zu zwei ein- oder ausgangsseitigen Anschlüssen des Filters oder des Reaktanzserienelements (VS) zumindest ein Reaktanzelement (RP) parallel geschaltet ist.

6. Filter nach Anspruch 5,
bei dem das parallel geschaltete Reaktanzelement (RP) aus der Serienschältung zweier Resonatoren (RP1,RP2) besteht.

7. Filter nach Anspruch 5 oder 6,
bei dem das parallel geschaltete Reaktanzelement (RP) einen zwischen zwei Reflektoren (RF) angeordneten Interdigitalwandler (IDT) aufweist, dessen eine Stromschiene achsensymmetrisch in zwei Teilschienen (TS1,TS2) aufgeteilt ist, die jeweils mit einem der beiden Anschlüsse des Resonators verbunden sind (FIG 4).

8. Filter nach einem der Ansprüche 1-7,
bei dem ein Interdigitalwandler des Reaktanzserienelements (VS) kaskadengewichtet ist und daher zumindest zum Teil aus in transversaler Richtung serienverschalteten Teilwandlern besteht.

9. Filter nach einem der Ansprüche 1-7
bei dem ein Interdigitalwandler des Reaktanzserienelements (VS) weglassgewichtet oder überlappgewichtet ist.

10. Filter nach einem der Ansprüche 1-9,
bei dem eines der Reaktanzelemente oder ein DMS Filter zwei nebeneinander liegende Oberflächenwellenstrukturen, ausgewählt aus Interdigitalwandler und Reflektor, aufweist, die gegeneinander phasenverschoben sind, wobei die Fingerperiode im Bereich des Übergangs ein Minimum aufweist und von beiden Seiten her kontinuierlich abnimmt.

11. Filter nach einem der Ansprüche 1-10,
das auf einem Substrat aufgebaut ist, welches ausgewählt ist aus Lithiumtantalat und Lithiumniobat.

12. Filter nach einem der Ansprüche 1-11,
bei dem die Filter und die Reaktanzelemente eine Metallisierung aufweisen, die Aluminium, Aluminium und Kupfer oder Aluminium und Magnesium enthält.

13. Filter nach einem der Ansprüche 1-12,
bei dem die Ein- und Ausgänge (IN;OUT) des Filters mit Anschlusspads auf dem Substrat verbunden sind, die wiederum über Bumps in Flipchip Technik auf eine Basisplatte kontaktiert sind.

## Claims

1. RF filter comprising reactance elements on an SAW basis,
- which is constructed on a piezoelectric substrate,
- which is configured in balanced/balanced fashion and therefore has a balanced input (IN) and a balanced output (OUT) each having two terminals,
- which is constructed in electrically balanced fashion,
- comprising a four-pole reactance series element (VS) having two input-side terminals and two output-side terminals,
- wherein both input- or output-side terminals (IN; OUT) of the reactance series element (RS) are cascade-connected to a balanced input or output of a balanced DMS filter (DMS),
- wherein the reactance series element (RS) is an individual balanced reactance element (VS) on an SAW basis which has two interdigital transducers (IDT) arranged between two reflectors.

2. RF filter according to Claim 1,
wherein the DMS filter has three interdigital transducers,
wherein the middle one of the three interdigital transducers, by symmetrical division of a busbar, is provided with two terminals (IN) lying on one side of the acoustic track, while the two outer interdigital transducers are connected to the output (OUT).

3. Filter according to Claim 1 or 2,
- wherein at least one parallel branch (PA) is provided in which a resonator (RP) is arranged, which is connected between a first and a second serial path (SP1SP2),
wherein one respective pole of the first and second serial paths form the balanced input (IN) and the respective other poles of the first and second serial paths form the balanced output (OUT) of the filter.

4. Filter according to any of Claims 1-3,
which is connected up in cascade with at least one further DMS filter (DMS2).

5. Filter according to any of Claims 1-4,
wherein at least one reactance element (RP) is connected in parallel with two input- or output-side terminals of the filter or of the reactance series element (VS).

6. Filter according to Claim 5,
wherein the parallel-connected reactance element (RP) comprises the series connection of two resonators (RP1, RP2).

7. Filter according to Claim 5 or 6,
wherein the parallel-connected reactance element (RP) has an interdigital transducer (IDT) which is arranged between two reflectors (RF) and one busbar of which is divided axially symmetrically into two partial busbars (TS1, TS2) which are respectively connected to one of the two terminals of the resonator (FIG.4).

8. Filter according to any of Claims 1-7,
wherein an interdigital transducer of the reactance series element (VS) is cascade-weighted and therefore at least partly comprises partial transducers connected up in series in a transverse direction.

9. Filter according to any of Claims 1-7,
wherein an interdigital transducer of the reactance series element (VS) is omission-weighted or overlap-weighted.

10. Filter according to any of Claims 1-9,
wherein one of the reactance elements or a DMS filter has two mutually adjacent surface acoustic wave structures, selected from interdigital transducer and reflector, which are phase-shifted relative to one another, wherein the finger period has a minimum in the region of the transition and decreases continuously from both sides.

11. Filter according to any of Claims 1-10,
which is constructed on a substrate selected from lithium tantalate and lithium niobate.

12. Filter according to any of Claims 1-11,
wherein the filters and the reactance elements have a metallization containing aluminium, aluminium and copper or aluminium and magnesium.

13. Filter according to any of Claims 1-12,
wherein the inputs and outputs (IN; OUT) of the filter are connected to terminal pads on the substrate, which are in turn contact-connected onto a baseplate by means of bumps using flip-chip technology.

## Revendications

1. Filtre HF ayant des éléments de réactance à base d'ondes de surface
- qui est formé sur un substrat piézoélectrique
- qui a une configuration équilibré/équilibré et donc une entrée (IN) symétrique et une sortie (OUT) symétrique ayant respectivement deux bornes
- qui est constitué symétriquement du point de vue électrique
- comprenant un élément (VS) série de réactance tétrapolaire ayant deux bornes côté entrée et deux bornes côté sortie,
- dans lequel deux bornes (IN ; OUT) côté entrée ou côté sortie de l'élément (RS) série de réactance sont reliées en cascade avec une entrée ou une sortie symétrique d'un filtre (DMS) DMS symétrique
- dans lequel l'élément (RS) série de réactance est un élément (VS) de réactance symétrique individuel à base d'ondes de surface qui a deux convertisseurs (IDT) interdigités disposés entre deux réflecteurs.

2. Filtre HF suivant la revendication 1,
dans lequel le filtre DMS a trois convertisseurs interdigités, le convertisseur médian des trois convertisseurs interdigités étant muni par répartition symétrique d'une barre de courant ayant deux bornes (IN) se trouvant d'un côté de la trace acoustique, tandis que les deux convertisseurs interdigités extérieurs sont reliés à la sortie (OUT).

3. Filtre suivant la revendication 1 ou 2,
- dans lequel il est prévu au moins une branche (PA) parallèle dans laquelle est monté un résonateur (RP) qui est monté entre un premier et un deuxième chemins (SP1SP2) série
dans lequel respectivement un pôle du premier et du deuxième chemins série forme l'entrée (IN) symétrique et l'autre pôle respectif du premier et du deuxième chemin série forme la sortie (OUT) symétrique du filtre.

4. Filtre suivant l'une des revendications 1 à 3,
qui est monté en cascade avec au moins un autre filtre (DMS2) DMS.

5. Filtre suivant l'une des revendications 1 à 4,
dans lequel au moins un élément (RP) de réactance est monté en parallèle avec deux bornes côté entrée ou côté sortie du filtre ou de l'élément (VS) série de réactance.

6. Filtre suivant la revendication 5,
dans lequel l'élément (RP) de réactance monté en parallèle est constitué du circuit série de deux résonateurs (RP1, RP2).

7. Filtre suivant la revendication 5 ou 6,
dans lequel l'élément (RP) de réactance monté en parallèle a un convertisseur (IDT) interdigité, qui est disposé entre deux réflecteurs (RF) et dont une barre de courant est réparti d'une manière symétrique par rapport à un axe en deux sous-barres (TS1, TS2) reliées respectivement à l'une des deux bornes du résonateur (FIG 4).

8. Filtre suivant l'une des revendications 1 à 7,
dans lequel un convertisseur interdigité de l'élément (VS) série de réactance est pondéré en cascade et est donc constitué au moins en partie de sous-convertisseurs montés en série dans la direction transversale.

9. Filtre suivant l'une des revendications 1 à 7,
dans lequel un convertisseur interdigité de l'élément (VS) série de réactance est pondéré en suppression ou en superposition.

10. Filtre suivant l'une des revendications 1 à 9,
dans lequel l'un des éléments de réactance ou un filtre (DMS) a deux structures à ondes de surface côte à côte choisies parmi des convertisseurs interdigités et des réflecteurs, qui sont déphasées l'une par rapport à l'autre, la période des doigts ayant un minimum dans la zone de la transition et diminuant continuellement à partir des deux côtés.

11. Filtre suivant l'une des revendications 1 à 10,
qui assemblé sur un substrat choisi parmi le tantalate de lithium et le niobate de lithium.

12. Filtre suivant l'une des revendications 1 à 11,
dans lequel le filtre et les éléments de réactance ont une métallisation qui contient de l'aluminium, de l'aluminium et du cuivre ou de l'aluminium et du magnésium.

13. Filtre suivant l'une des revendications 1 à 12,
dans lequel les entrées et sorties (IN ; OUT) du filtre sont reliées à des plages de borne sur le substrat, qui sont mises en contact à nouveau par des bossages suivant la technique flipchip sur une plaquette de base.
